# EUROPEAN PATENT APPLICATION

(11) **EP 4 530 072 A1**
(43) Date of publication of application: **02.04.2025**
(21) Application number: 24202059.2
(22) Date of filing: 23.09.2024
(51) Int. Cl.: B41F 13/008, B41F 15/08, B41F 15/36, H05K 3/12

(54) **PRINTING SYSTEM AND METHOD FOR CONTROLLING A PRINTING SYSTEM**

(30) Priority: 28.09.2023 CN 202311278328
(71) Applicant: Illinois Tool Works Inc., Glenview IL 60025 (US)
(72) Inventor: CHENG, Zaizai, Glenview, 60025 (US); ZHU, Liang, Glenview, 60025 (US); LIU, Linfeng, Glenview, 60025 (US); ZHANG, Jian, Glenview, 60025 (US)
(74) Representative: HGF

(57) **Abstract**

The present disclosure provides a printing system for printing a first board and a second board, the printing system including a conveying mechanism, a vacuum device and a drive component. The conveying mechanism is used to carry the first board. The vacuum device is used to carry the second board. The drive component drives at least one of the conveying mechanism and the vacuum device to enable the conveying mechanism or the vacuum device to drive the carried board. The present disclosure is directed to different types of boards, and printing of different types of boards is accomplished by controlling the components for carrying and driving the boards without dismounting or removing the vacuum device.

## Description

### TECHNICAL FIELD

The present disclosure relates to the technical field of stencil printing systems and, more particularly, to a printing system and a method for controlling a printing system.

### BACKGROUND

During manufacturing of surface-mount printed circuit boards, a printer may be used to print solder paste onto a circuit board so that electronic elements can be subsequently deposited onto the circuit board. A circuit board with a conductive surface is transferred into the printer and is properly aligned from below with an aperture on a stencil of the printer by means of one or more small holes or marks (called "fiducials") on the circuit board. Once the circuit board has been properly aligned with the stencil in the printer, the circuit board is raised to a height close to that of the stencil and then the solder paste is extruded from a solder paste jar onto the stencil. After the solder paste is dispensed onto the stencil, a scraper blade of the printer moves along an upper surface of the stencil to force the solder paste to flow through the aperture in the stencil to the conductive surface of the circuit board.

For different types of circuit boards, the printing system sometimes needs to be provided with different devices to assist printing. For some flexible circuit boards, for example, the printing system needs to use a vacuum device to suction the circuit board from below and raise the circuit board to facilitate printing of the circuit board. When printing other rigid circuit boards, the printing system does not require a vacuum device to suction the circuit board, but instead supports and raises the circuit board by means of a track mechanism.

### SUMMARY OF THE DISCLOSURE

In a first aspect, the present disclosure provides a printing system for printing a first board and a second board, the printing system including a conveying mechanism, a vacuum device and a drive component. The conveying mechanism is used to carry the first board. The vacuum device is used to carry the second board. The drive component drives at least one of the conveying mechanism and the vacuum device to enable the conveying mechanism or the vacuum device to drive the carried board.

According to the first aspect described above, the drive component is connected to the vacuum device to enable the drive component to drive the vacuum device to move. The printing system further includes a clutch mechanism, the clutch mechanism being configured to engage the drive component with the conveying mechanism to enable the drive component to drive the conveying mechanism to move; or disengage the drive component from the conveying mechanism to enable the drive component to move relative to the conveying mechanism.

According to the first aspect described above, the conveying mechanism is capable of conveying the first board and the second board in a first direction. The drive component is capable of driving at least one of the conveying mechanism and the vacuum device to move in a second direction.

According to the first aspect described above, the conveying mechanism includes a pair of conveying portions arranged oppositely in a third direction, and the vacuum device is arranged between the pair of conveying portions.

According to the first aspect described above, the first board and the second board each include an identification code. The printing system further includes an identification device, the identification device being configured to identify the identification codes of the first board and the second board to obtain parameter information.

According to the first aspect described above, the printing system further includes a control device, the control device being configured to be capable of receiving the parameter information obtained by the identification device and controlling the drive component and the clutch mechanism according to the parameter information.

According to the first aspect described above, the control device is configured to: control, when the first board is identified, the clutch mechanism to engage the drive component with the conveying mechanism such that the drive component simultaneously drives the conveying mechanism and the vacuum device to move so as to enable the conveying mechanism to drive the first board; and control, when the second board is identified, the clutch mechanism to disengage the drive component from the conveying mechanism such that the drive component drives the vacuum device to move so as to enable the vacuum device to drive the second board.

According to the first aspect described above, the printing system further includes a stencil. The stencil is arranged above the conveying mechanism. The drive component is configured to enable the conveying mechanism and the vacuum device to drive the carried boards to make the upper surfaces of the board move close to a lower surface of the stencil.

According to the first aspect described above, the clutch mechanism includes at least one clamp and at least one guide rod. Each of the at least one clamp is connected to the drive component to enable the drive component to drive the clamp to move. The at least one guide rod is arranged corresponding to the at least one clamp, and each of the at least one guide rod is connected to the conveying mechanism. Each of the at least one clamp is configured to be capable of clamping or releasing the corresponding guide rod to enable the drive component to engage with or disengage from the conveying mechanism.

According to the first aspect described above, the printing system further includes a frame. The frame includes a pair of first beams arranged oppositely in the third direction and a pair of second beams arranged oppositely in the first direction, the pair of first beams and the pair of second beams being connected to each other to form the frame. The pair of first beams are connected to the drive component and the clamp, and the pair of second beams are connected to the conveying mechanism and the guide rod.

According to the first aspect described above, the at least one clamp includes four clamps, and the at least one guide rod includes four guide rods, the four clamps and the four guide rods being respectively arranged at connections between the respective first beams and the corresponding second beams.

In a second aspect, the present disclosure provides a method for controlling a printing system, the method including: identifying a first board and a second board; conveying the first board and the second board in a first direction to a position aligned with each other; and driving at least one of a conveying mechanism and a vacuum device to enable the conveying mechanism to drive the first board or enable the vacuum device to drive the second board to a printing position.

According to the second aspect described above, driving at least one of a conveying mechanism and a vacuum device to enable the conveying mechanism to drive the first board or enable the vacuum device to drive the second board includes: allowing the clutch mechanism to engage the drive component with the conveying mechanism, when the first board is identified, to enable the drive component to drive the conveying mechanism and the vacuum device to move together so as to enable the conveying mechanism to drive the first board to move to the printing position; and allowing the clutch mechanism to disengage the drive component from the conveying mechanism, when the second board is identified, to enable the drive component to move relative to the conveying mechanism and drive the vacuum device to move so as to enable the vacuum device to drive the second board to move to an intermediate position.

According to the second aspect described above, driving at least one of a conveying mechanism and a vacuum device to enable the conveying mechanism to drive the first board or enable the vacuum device to drive the second board further includes: allowing the clutch mechanism to engage the drive component with the conveying mechanism, when the second board is identified and after the second board moves to the intermediate position, to enable the drive component to drive the conveying mechanism and the vacuum device to move together so as to enable the vacuum device to drive the second board to move to the printing position.

According to the second aspect described above, identifying a first board and a second board further includes: obtaining parameter information of the first board and the second board.

Other features, advantages and embodiments of the present disclosure may be elaborated or become apparent by considering the following specific embodiments, accompanying drawings and claims. Furthermore, it should be appreciated that the summary and the following specific embodiments are all exemplary, and are intended to provide a further explanation, but not to limit the scope of protection of the present disclosure. However, the specific embodiments and specific examples merely indicate preferred embodiments of the present disclosure. For those skilled in the art, various variations and modifications within the spirit and scope of the present disclosure will become apparent by the way of the specific embodiments.

### BRIEF DESCRIPTION OF THE DRAWINGS

FIG. 1A is a perspective view of the structure of a printing system according to an embodiment of the present disclosure;
FIG. 1B is a perspective view of the structure of the printing system of FIG. 1A with a housing removed;
FIG. 1C is an exploded view of the printing system of FIG. 1B with a holder further removed;
FIG. 2A is a structural diagram showing the assembly of a conveying mechanism, a drive component and a board to be printed of the printing system of FIG. 1C;
FIG. 2B is a right view of FIG. 2A;
FIG. 2C is an exploded view of FIG. 2A;
FIG. 3A is a structural schematic diagram of a first board;
FIG. 3B is a structural schematic diagram of a plurality of second boards;
FIG. 4A shows a structural schematic diagram of some assemblies of the printing system with the first board in an alignment position;
FIG. 4B shows a structural schematic diagram of some assemblies of the printing system with the first board in a printing position;
FIG. 5A shows a structural schematic diagram of some assemblies of the printing system with the second board in an alignment position;
FIG. 5B shows a structural schematic diagram of some assemblies of the printing system with the second board in an intermediate position;
FIG. 5C shows a structural schematic diagram of some assemblies of the printing system with the second board in a printing position;
FIG. 6 shows a block diagram of the structure of a control device; and
FIGS. 7A-7C show a partial flow diagram of a method for controlling a printing system.

### DETAILED DESCRIPTION OF EMBODIMENTS

Various specific implementations of the present disclosure are described below with reference to the drawings which constitute part of this specification. It should be understood that although the terms such as "front", "rear", "upper", "lower", "left" and "right" indicating directions are used in the present disclosure to describe various exemplary structural parts and elements of the present disclosure, these terms are used herein only for ease of description and are determined based on the exemplary orientations shown in the drawings. Since the arrangements in the embodiments disclosed in the present disclosure may be in various directions, these terms indicating directions are only illustrative and should not be considered as limitations. If possible, the same or similar reference signs used in the present disclosure refer to the same components. In addition, the terms "steel mesh" and "stencil" may be used interchangeably herein, both of which are used to describe a device in a stencil printer that defines a pattern to be printed on a substrate (i.e., a printed circuit board).

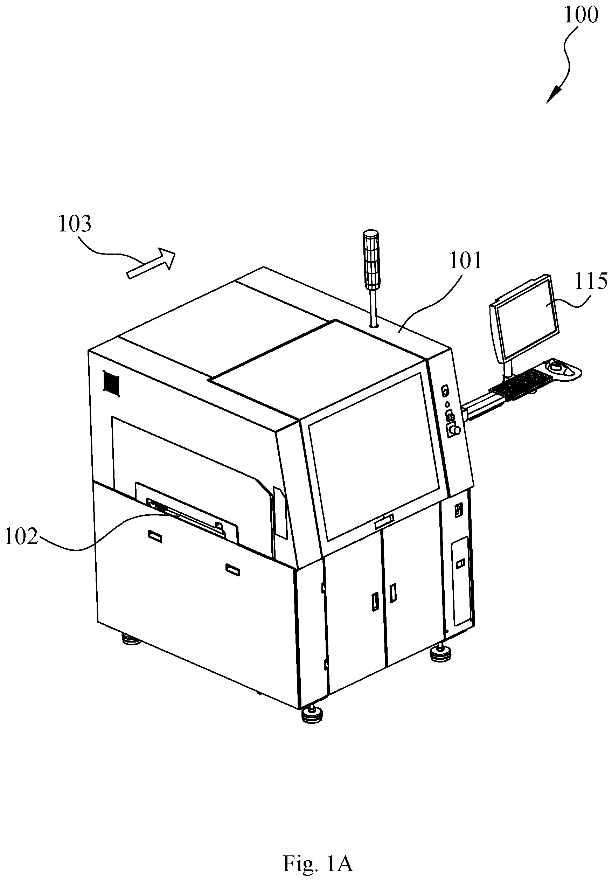

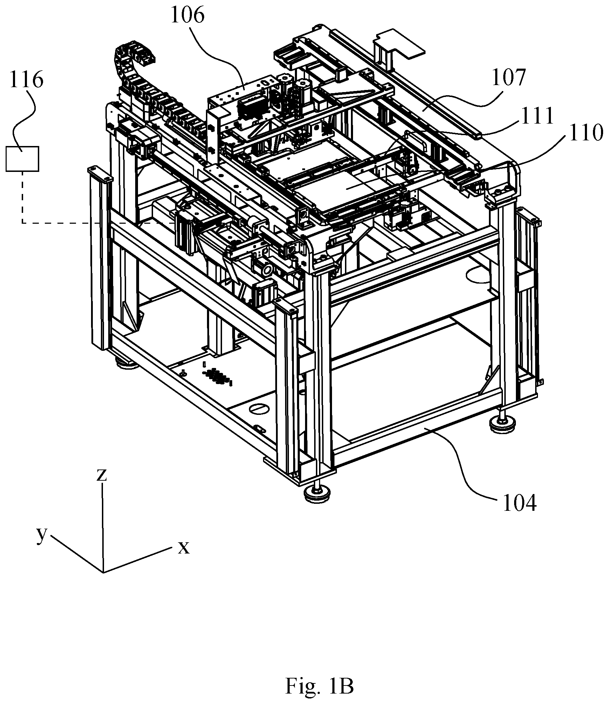

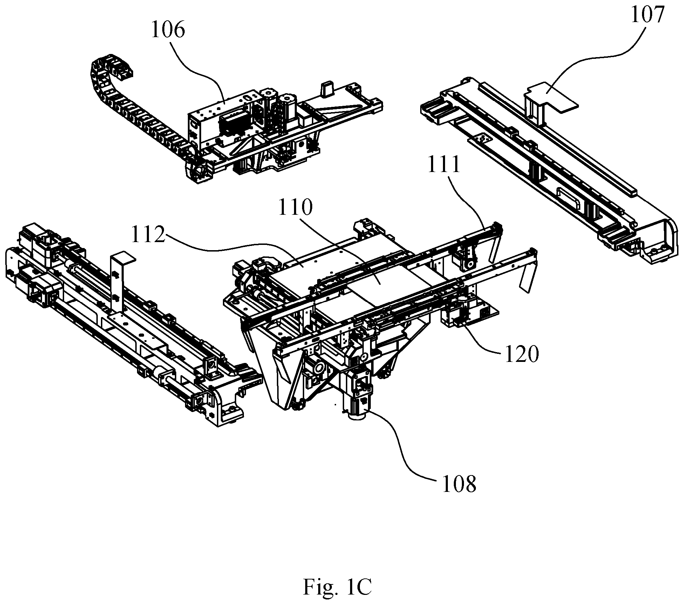

FIGS. 1A-1C show the general structure of a printing system 100. FIG. 1A is a perspective view of the external structure of the printing system 100 according to an embodiment of the present disclosure, FIG. 1B shows the internal structure of the printing system 100 with a housing 101 removed, and FIG. 1C shows an exploded view of the printing system 100 with the housing 101 removed and a holder 104 further removed. As shown in FIG. 1A, the printing system 100 includes the housing 101 having a substantially square shape, and a control device 115. The control device 115 is configured to convey a circuit board to be printed from an inlet 102 of the printing system into the interior of the printing system 100 in a conveying direction 103 as indicated by the arrow (i.e., a first direction or x direction), and to output the board from an outlet (not shown) after printing is completed.

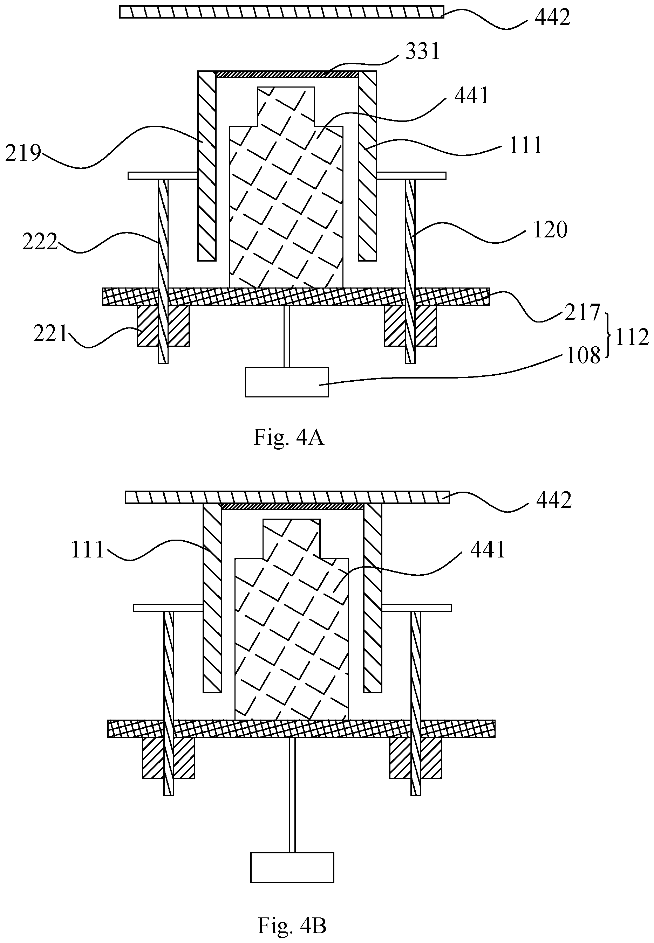

As further shown in FIGS. 1B-1C, the printing system 100 further includes a holder 104. The holder 104 is used to support components of the printing system 100. The components of the printing system 100 include: a print head 106, a pair of stencil holders 107, a conveying mechanism 111 and a drive component 112. The conveying mechanism 111 is used to convey the board 110 to be printed in the conveying direction 103. The drive component 112 is arranged below the conveying mechanism 111 for driving the board 110 to be printed to ascend and descend in an up and down direction (i.e., in a second direction or z direction). The drive component 112 includes a drive motor 108. The pair of stencil holders 107 are arranged above the conveying mechanism 111, where the stencil holders 107 are used to support a stencil (not shown, see a stencil 442 in FIGS. 4A-5C), in the stencil, hollow-out holes are provided for defining the position of solder paste printed onto the board 110 to be printed. The print head 106 is arranged above the stencil, and the print head 106 is used to distribute the solder paste onto the stencil, and then move a scraper blade along an upper surface of the stencil to force the solder paste through the hole in the stencil to a designated position on an upper surface of the board 110 to be printed.

It should be noted that the first direction x, the second direction z, and a third direction y herein are substantially perpendicular to one another.

For the printing system 100, the general printing process of printing the board 110 to be printed is as follows.

The board 110 to be printed has an alignment position and a printing position. The controller 115 first controls the conveying mechanism 111 to convey the board 110 to be printed from the inlet 102 to the alignment position below the stencil and aligned with the stencil. The controller 115 then controls the drive component 112 to ascend, and the drive component 112 drives the board 110 to be printed to a position very close to the stencil or to a printing position where the upper surface of the board 110 is in contact with a lower surface of the stencil. The controller 115 then controls the print head 106 to print the solder paste through the hole of the stencil onto the board 110 to be printed. After printing is completed, the controller 115 controls the drive component 112 to descend, and the drive component 112 drives the board 110 to be printed to descend to a position away from the stencil. Finally, the controller 115 controls the conveying mechanism 111 to convey the board 110 to be printed to exit the printing system 100 from the outlet. In this way, the printing process of one board 110 to be printed can be completed, waiting for the printing of a next board.

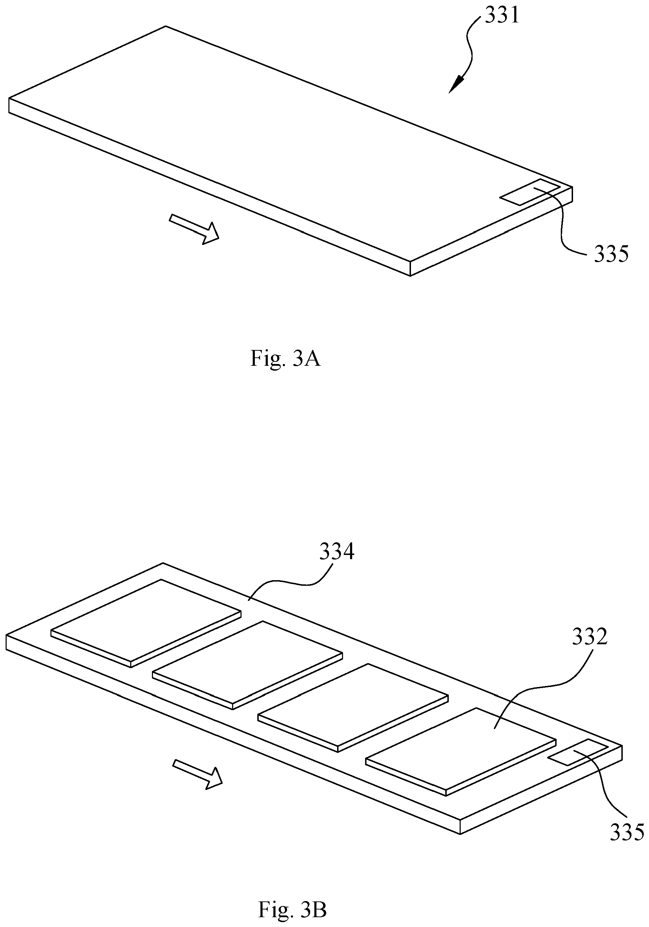

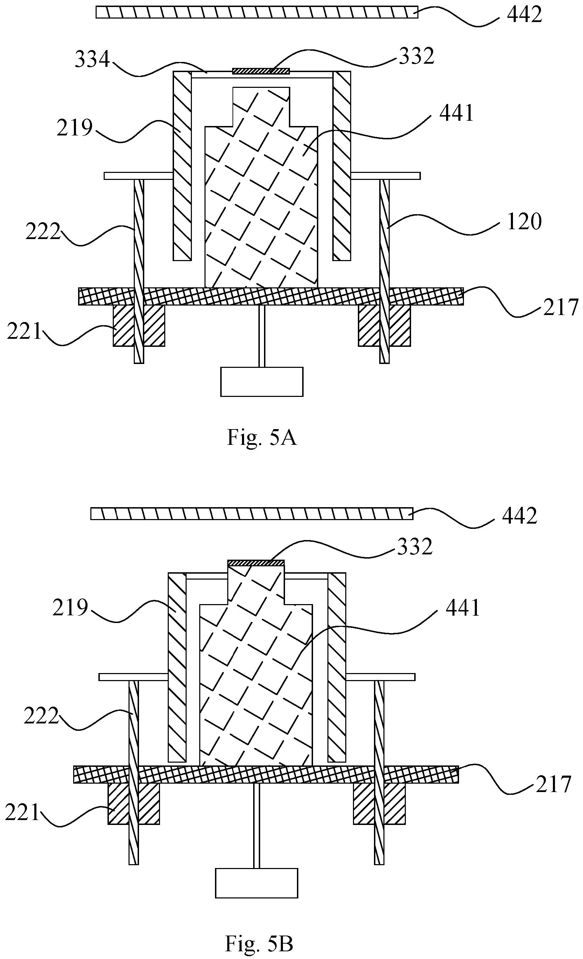

Depending on the type of board 110 to be printed, the more specific printing process of the printing system 100 may vary. For some rigid, large-sized boards (see a first board 331 in FIG. 3A), the first board 331 is mounted directly to the conveying mechanism 111 and carried by the conveying mechanism 111. The drive component 112 can raise the position of the first board 331 to the printing position directly by driving the conveying mechanism 111. For some flexible, small-sized boards (see a second board 332 in FIG. 3B), the second board 332 needs to be loaded on a carrier 334 before being mounted to the conveying mechanism 111. In order to prevent the flexible second board 332 from flexing, warping, etc., during printing of the second board 332, the second board 332 also needs to be suctioned and carried from below by a vacuum device (see a vacuum device 441 shown in FIGS. 5A-5C). Moreover, the drive component 112 drives the vacuum device 441 to eject the second board 332 from the carrier 334 and raise the second board to the printing position.

It should be noted that the conveying mechanism 111 carrying and driving the first board 331 or the vacuum device carrying and driving the second board 332 in this embodiment refers to a device for carrying and driving the corresponding board after the corresponding board has reached the alignment position. The board is carried and conveyed by the conveying mechanism 111 either in a process before it reaches the alignment position, or in a process of exiting the alignment position after the printing is completed.

The printing system 100 further includes an identification device 116. The identification device 116 is used to identify the type of board 110 to be printed (e.g., the first board 331 or the second board 332) and some other parameters. In this embodiment, the identification device 116 is arranged at the inlet 102 such that the board 110 can be identified by the identification device 116 as it is conveyed into the inlet 102 by the conveying mechanism 111, and on this basis, the way in which the drive component 112 drives the board 110 to ascend to the printing position after the board 110 has been conveyed to the alignment position is determined.

In this embodiment, the vacuum device is directly connected to the drive component 112 so that the drive component 112 drives the vacuum device to move. In order to prevent the vacuum device from interfering with or influencing the printing of the first board 331 when printing the first board 331 and prevent the vacuum device from ejecting the second board 332 away from the carrier 334 when printing the second board 332, the printing system 100 further includes a clutch mechanism 120. The clutch mechanism 120 can engage the drive component 112 with the conveying mechanism 111 such that the drive component 112 can directly drive the conveying mechanism 111 to move. That is, the drive component 112 drives the vacuum device and the conveying mechanism 111 to move together. Furthermore, the clutch mechanism 120 can disengage the drive component 112 from the conveying mechanism 111 such that the drive component 112 can move relative to the conveying mechanism 111. That is, the drive component 112 only drives the vacuum device to move but does not drive the conveying mechanism 111 to move.

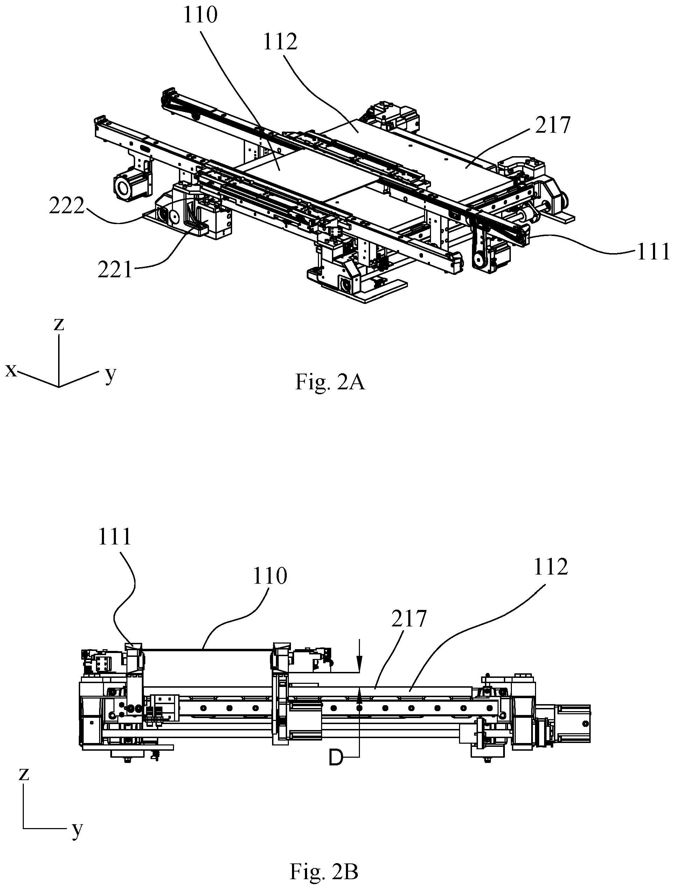

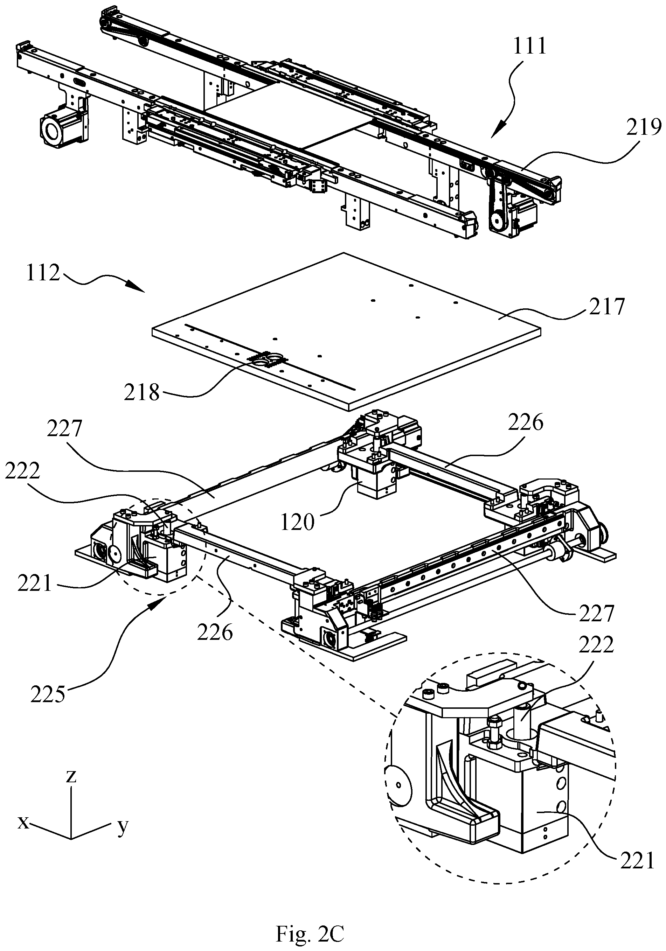

FIGS. 2A-2C show a more specific internal structure of the printing system 100 with the print head 106 and the stencil holder 107 of FIG. 1C further removed. FIG. 2A is a structural diagram showing the assembly of the conveying mechanism 111, the drive component 112 and the board 110 to be printed, FIG. 2B is a right view of FIG. 2A, and FIG. 2C is an exploded view of FIG. 2A. As shown in FIGS. 2A-2C, the conveying mechanism 111 includes a pair of conveying portions 219, and the board 110 to be printed is clamped between the pair of conveying portions 219 and is conveyed in the x direction (i.e., in the conveying direction 103 in FIG. 1A). The pair of conveying portions 219 are arranged oppositely and spaced apart in the third direction (i.e., in the y direction) and may move closer to or away from each other to accommodate to different widths of the board 110 to be printed. In this embodiment, the board 110 to be printed is a first board 331, the upper surface of which is substantially flush with upper surfaces of the conveying portions 219, so that when the drive component 112 drives the conveying mechanism 111 to move in the z direction to lower surfaces of the conveying portions 219 that abut against the stencil, the board 110 can be very close to or in contact with the lower surface of the stencil.

The drive component 112 includes a support table 217. The support table 217 is substantially square. The drive motor 108 is connected below the support table 217, and is configured to drive the support table 217 to ascend or descend in the z direction. The support table 217 is provided with a vacuum device mounting hole 218 at a corresponding position between the pair of conveying portions 219 and below the stencil. The vacuum device mounting hole 218 is used for mounting the vacuum device so that the vacuum device can be located between the pair of conveying portions 219. Moreover, when the conveying mechanism 111 conveys the board 110 to be printed below the stencil, the vacuum device is located below the board 110 to be printed. An upper surface of the support table 217 is spaced from the bottoms of the pair of conveying portions 219 by a distance D. By setting this distance D, the support table 217 can have a space for making relative movement with respect to the conveying portions 219.

The printing system 100 further includes a frame 225. The frame 225 is substantially in the shape of a square frame. The frame 225 includes a pair of first beams 226 arranged oppositely in the y direction and a pair of second beams 227 arranged oppositely in the x direction. The pair of first beams 226 and the pair of second beams 227 are connected to each other to form the frame 225 in the shape of a square frame.

The pair of first beams 226 are fixedly connected to the support table 217 of the drive component 112, for example, by bolts or the like. In this embodiment, at four corners of the square support table 217, two ends of each of the pair of first beams 226 are connected to the support table so that the ascending/descending movement of the support table 217 in the z direction can drive the frame 225 to move in a balanced manner.

The pair of second beams 227 are connected to the conveying mechanism 111, for example, by bolts or the like. In this embodiment, two ends of each conveying portion 219 of the conveying mechanism 111 are connected to one of the pair of second beams 227, respectively, so that the pair of conveying portions 219 can maintain a horizontal ascending/descending movement, so as to facilitate the adjustment of the distance between the pair of conveying portions 219 spaced in the y direction.

The clutch mechanism 120 includes at least one clamp 221 and at least one guide rod 222 arranged corresponding to each other. The clamp 221 is connected to the drive component 112, and the guide rod 222 is connected to the conveying mechanism 111. Moreover, each clamp 221 can clamp or release the corresponding guide rod 222 to enable the drive component 112 to engage with or disengage from the conveying mechanism 111. In this embodiment, the clutch mechanism 120 is connected between the first beam 226 and the second beam 227, the clamp 221 is connected to the first beam 226, and the guide rod 222 is connected to the second beam 227. In this way, the clamp 221 clamps or releases the respective guide rod 222 to enable the first beam 226 to engage with or disengage from the second beam 227, thereby causing the drive component 112 to engage with or disengage from the conveying mechanism 111. As an example, the clutch mechanism 120 includes four clamps 221 and four guide rods 222. The four clamps 221 and the four guide rods 222 are arranged at four corners of the frame 225, respectively. For example, each clamp 221 is connected below an end portion of the respective first beam 226, the top of each guide rod 222 is connected to an end portion of the respective second beam 227, and the lower end of each guide rod 222 extends into the respective clamp 221 so as to be clamped or released by the clamp 221. As an example, the clamp 221 includes an air cylinder which can clamp the guide rod 222 when the air cylinder is supplied with air and release the guide rod 222 when the air cylinder is not supplied with air. Such an arrangement ensures that the ascending/descending movement of the drive component 112 and the conveying mechanism 111 in the z direction is substantially horizontal and balanced. In other embodiments, the clutch mechanism may also be provided in other positions and in other numbers, and may be provided in other clutchable structures, so long as that the drive component 112 can engage with or disengage from the conveying mechanism 111.

FIGS. 3A and 3B show a structural schematic diagram of the board 110 to be printed, where FIG. 3A shows a structural schematic diagram of the first board 331 and FIG. 3B shows a structural schematic diagram of the second board 332. As shown in FIG. 3A, the first board 331 is a rigid circuit board, the upper surface of which is used for printing, and two sides of which are clamped by the pair of conveying portions 219 of the conveying device 111, respectively. The first board 331 is provided with an identification code 335 at a front end thereof in the conveying direction.

The second board 332 is a flexible circuit board. A plurality of second boards 332 are carried by the carrier 334 and enter the printing system at the same time for printing. During conveying, two sides of the carrier 334 are clamped on the pair of conveying portions 219 of the conveying device 111, respectively. During printing, the vacuum device ejects the second boards 332 from the carrier 334 in turn, to complete the printing in turn. An identification code 335 of the second board 332 is provided at a front end of the carrier 334 in the conveying direction.

The identification codes 335 of the first board 331 and the second board 332 may be identified by the identification device 116 to obtain parameter information. As an example, the identification code 335 may include various parameter data in addition to the identification of the type of board. The parameter data is, for example, the number, size and thickness data of boards, the properties, size, and position data of the stencil, dimensions, conveying speed data of the conveying mechanism, data of the print head such as scraper blade pressure, printing speed and scraper blade gap, dispensing data such as dispensing machine information, the number of dispensing times, dispensing speed, dispensing frequency, gluing delay and end delay, desizing monitoring information data, and demolding data such as demolding speed and demolding distance. The control device 115 may control the operation of the printing system after receiving the parameters identified by the identification device 116.

FIGS. 4A and 4B show a structural schematic diagram showing the assembly of the various components of the printing system during the printing of the first board 331. FIG. 4A shows the structures of the components of the printing system with the first board 331 in the alignment position. FIG. 4B shows the structures of the components of the printing system with the first board 331 in the printing position. As shown in FIG. 4A, the first board 331 is clamped between the pair of conveying portions 219 of the conveying mechanism 111. When the conveying mechanism 111 conveys the first board 331 to the alignment position, the vacuum device 441 is located below the first board 331, and the conveying mechanism 111 is spaced a distance from the support table 217. The clutch mechanism 120 engages the drive component 112 with the conveying mechanism 111. In this embodiment, the drive component 112 and the conveying mechanism 111 are engaged with each other such that the clamp 221 clamps the guide rod 222. The control device 115 controls the drive component 112 to drive the conveying mechanism 111 and the vacuum device 441 to move upwardly together in the z direction until the conveying mechanism 111 drives the carried first board 331 to the printing position as shown in FIG. 4B.

As shown in FIG. 4B, the upper surface of the first board 331 is close to or in contact with the lower surface of the stencil 442, and the print head may print the solder paste to the first board 331. After printing is completed, the drive component 112 then drives the conveying mechanism 111 to move downwardly in the z direction to the alignment position. The conveying mechanism 111 then continues to convey the first board 331 until the first board exits the printing system 100. In this process, the vacuum device 441 moves up or down in synchrony with the support table 217 of the drive component 112 and the conveying mechanism 111, so that the vacuum device 441 does not interfere with the printing of the first board 331, but remains below the first board 331 at all times.

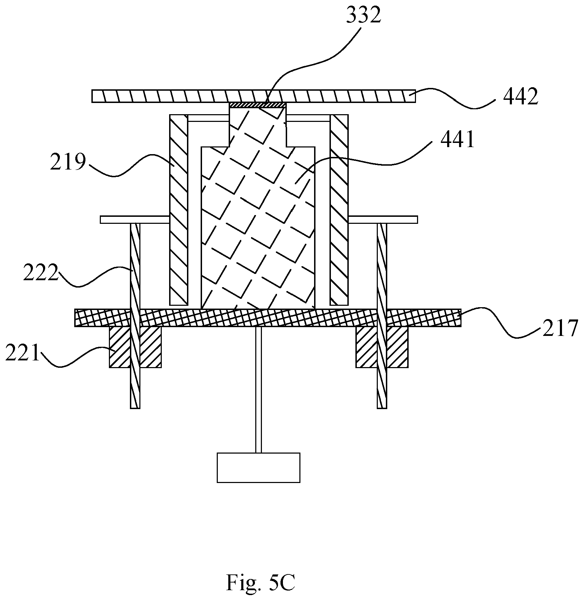

FIGS. 5A-5C show a structural schematic diagram of the various components of the printing system during the printing of the second board 332. FIG. 5A shows the structures of the components of the printing system with the second board 332 in the alignment position. FIG. 5B shows the structures of the components of the printing system with the second board 332 in the intermediate position. FIG. 5C shows the structures of the components of the printing system with the second board 332 in the printing position. As shown in FIG. 5A, the second board 332 is clamped by the carrier 334 between the pair of conveying portions 219 of the conveying mechanism 111. When the conveying mechanism 111 conveys the second board 332 to the alignment position, the vacuum device 441 is located below the first board 331, and the conveying mechanism 111 is spaced a distance from the support table 217. The clutch mechanism 120 disengages the drive component 112 from the conveying mechanism 111. In this embodiment, that drive component 112 and the conveying mechanism 111 are disengaged from each other such that the clamp 221 releases the guide rod 222. The control device 115 controls the movement of the drive component 112 relative to the conveying mechanism 111, that is, driving the vacuum device 441 to moved upwardly in the z direction, but the conveying mechanism 111 does not move until the vacuum device 441 drives the carried second board 332 to the intermediate position as shown in FIG. 5B.

As shown in FIG. 5B, the support table 217 is raised upwardly relative to the conveying mechanism 111, so that the distance between the support table 217 and the conveying portion 219 is reduced. The vacuum device 441 is driven by the support bar 217 of the drive component 112 to move upwardly, so as to eject the second board 332 out of the carrier 334. In this case, the control device 115 can activate the vacuum device 441 so that the vacuum device 441 suctions the second board 332. The clutch mechanism 120 then engages the drive component 112 with the conveying mechanism 111. In this embodiment, the drive component 112 and the conveying mechanism 111 are engaged with each other such that the clamp 221 clamps the guide rod 222. The control device 115 controls the drive component 112 to drive the conveying mechanism 111 and the vacuum device 441 to move upwardly together in the z direction until the vacuum device 441 drives the carried second board 332 to the printing position as shown in FIG. 5C.

As shown in FIG. 5C, the upper surface of the second board 332 is close to or in contact with the lower surface of the stencil 442, and the print head may print the solder paste to the second board 332. After the printing is completed, the drive component 112 first drives the vacuum device 441 and the conveying mechanism 111 to move downwardly together in the z direction to the intermediate position, and the clamp 221 then releases the guide rod 222, so that the vacuum device 441 and the support table 217 continue to descend to the alignment position relative to the conveying mechanism 111. The conveying mechanism 111 then continues to convey the next second board 332 on the carrier 334 to the alignment position until after printing of all the second boards 332 on the carrier 334 is completed, and the conveying mechanism 111 then conveys the carrier 334 until the carrier exits the printing system 100.

In this way, the printing of the first board 331 or the second board 332 can be completed by the drive component 112 driving both the conveying mechanism 111 and the vacuum device 441 or only the vacuum device 441.

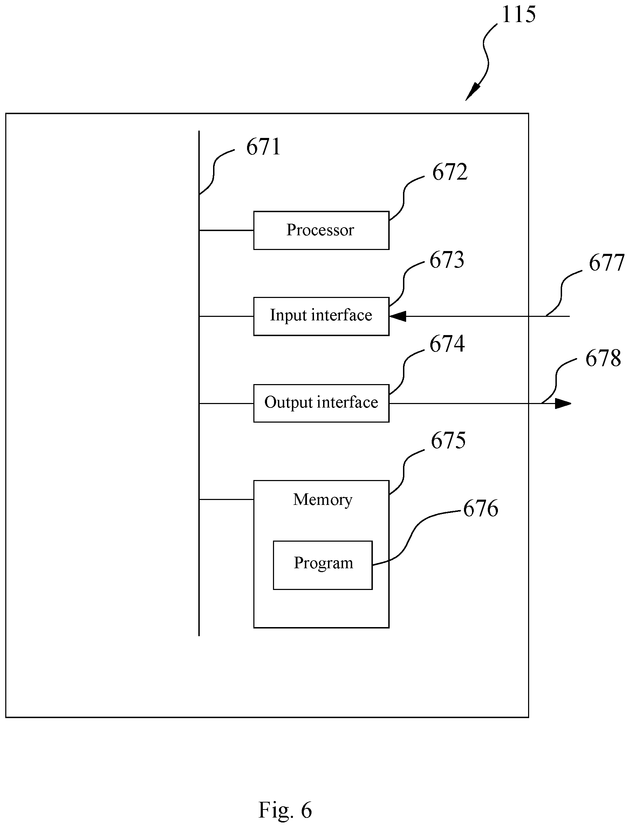

FIG. 6 shows a block diagram of the structure of the control device 115. As shown in FIG. 6, the control device 115 includes a bus 671, a processor 672, an input interface 673, an output interface 674, and a memory 675 having a control program 676. The components in the control device 115, including the processor 672, the input interface 673, the output interface 674 and the memory 675, are communicatively connected to the bus 671, such that the processor 672 can control operations of the input interface 673, the output interface 674 and the memory 675. Specifically, the memory 675 is configured to store programs, instructions and data, and the processor 672 reads the programs, instructions and data from the memory 675 and can write data to the memory 675. The processor 672 controls the operations of the input interface 673 and the output interface 674 by means of executing the programs and the instructions read from the memory 675.

As shown in FIG. 6, the input interface 673 is communicatively connected to the identification device 116 via connection 677, to receive various parameters of the identification code 335 identified by the identification device 116 and store these parameters in the memory 675. The output interface 674 is communicatively connected to the drive component 112 and the clutch mechanism 120 via connection 678. By executing the program 676 in the memory 675, the control device 115 controls the clutch mechanism 120 to move the drive component 112 and the conveying mechanism 111 together or relative to each other, and controls the drive component 112 to enable the conveying mechanism 111 or the vacuum device 441 to drive their respective carried first board 331 or second board 332 to move from the alignment position to the printing position. In addition, the control device 115 is communicatively connected to the print head 106 to control the printing process of the print head 106 in accordance with the identified parameters.

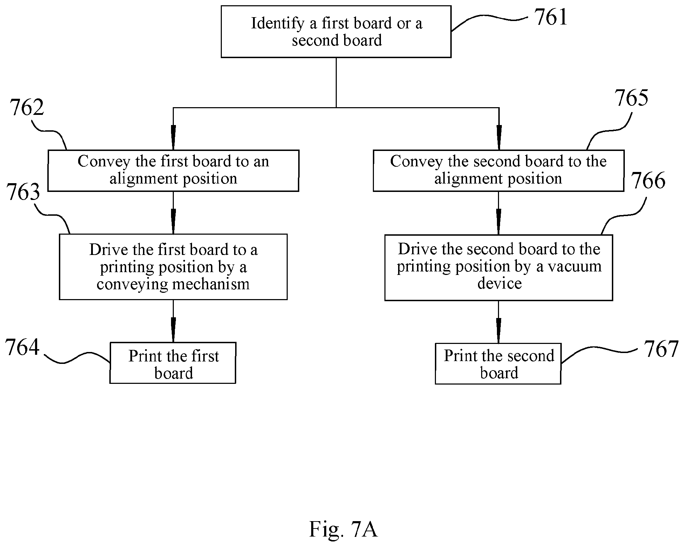

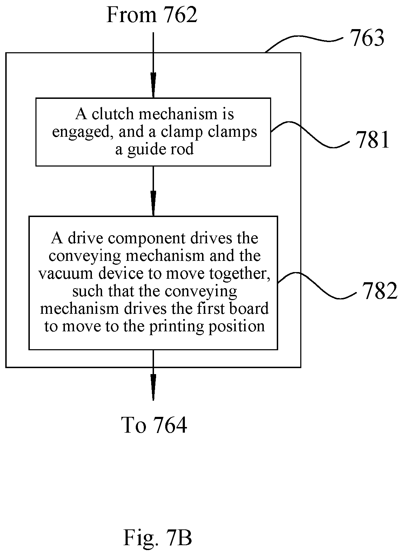

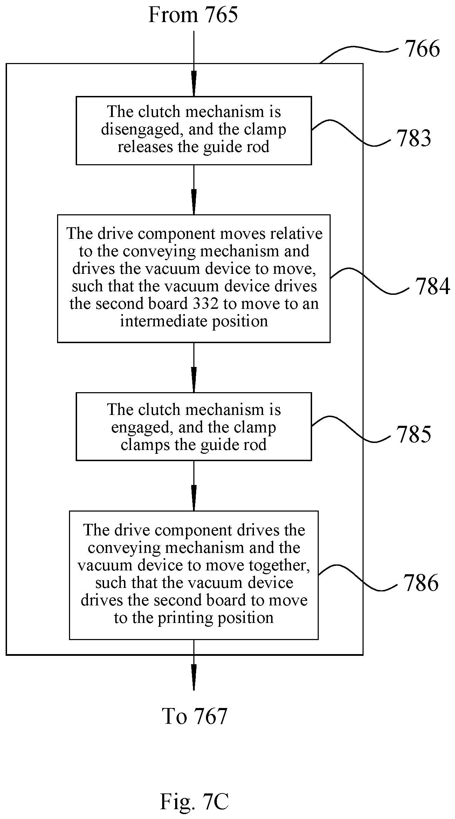

FIGS. 7A-7C show a partial flow diagram of a method for controlling a printing system. As shown in FIGS. 7A-7C, at step 761, various parameter information of the first board 331 or the second board 332 is identified.

If the board to be printed is the first board 331, step 762 is performed.

At step 762, the first board 331 is conveyed to the alignment position, and then step 763 is performed.

At step 763, the conveying mechanism 111 drives the first board 331 to the printing position, and then step 764 is performed.

At step 764, the first board 331 is printed.

After printing is completed, the conveying mechanism 111 drives the first board 331 back to the alignment position and then conveys the first board 331 away from the printing system.

If the board to be printed is the second board 332, step 765 is performed.

At step 765, the second board 332 is conveyed to the alignment position, and then step 766 is performed.

At step 766, the vacuum device 441 drives the second board 332 to the printing position, and then step 767 is performed.

At step 767, the second board 332 is printed.

After printing is completed, the vacuum device drives the second board 332 back to the alignment position and then conveys the next second board to the alignment position until all the second boards 332 on the carrier is printed, and all the second boards are then conveyed away from the printing system.

The steps performed at step 763 are as follows.

At step 781, the clutch mechanism 120 is engaged, the clamp 221 clamps the guide rod 222, and then step 782 is performed.

At step 782, the drive component 112 drives the conveying mechanism 111 and the vacuum device 441 to move together, such that the conveying mechanism 111 drives the first board 331 to move to the printing position.

Moreover, the steps performed at step 766 are as follows.

At step 783, the clutch mechanism 120 is disengaged, the clamp 221 releases the guide rod 222, and then step 784 is performed.

At step 784, the drive component 112 moves relative to the conveying mechanism 111 and drives the vacuum device 441 to move, such that the vacuum device 441 drives the second board 332 to move to the intermediate position, and then step 785 is performed.

At step 785, the clutch mechanism 120 is engaged, the clamp 221 clamps the guide rod 222, and then step 786 is performed.

At step 786, the drive component 112 drives the conveying mechanism 111 and the vacuum device 441 to move together, such that the vacuum device 441 drives the second board 332 to the printing position.

In some printing systems, different types of boards need to be printed with the same equipment. When switching the processes of printing different types of boards, it is also necessary to install or remove the vacuum device depending on difference of the board. Frequently installing or removing the vacuum device may result in damage to the stencil and complicated manual operations.

The present disclosure is directed to different types of boards, and printing of different types of boards is accomplished by controlling the components for carrying and driving the boards without removing the vacuum device.

Moreover, the identification codes of the boards of the present disclosure may carry parameter data of various boards and printing processes, so that the control device can control the printing process according to the parameter data.

Although the present disclosure is described with reference to the examples of embodiments outlined above, various alternatives, modifications, variations, improvements and/or substantial equivalents, which are known or anticipated at present or to be anticipated before long, may be obvious to those of at least ordinary skill in the art. In addition, the technical effects and/or technical problems described in this specification are exemplary rather than limiting. therefore, the disclosure in this specification may be used to solve other technical problems and may have other technical effects. Accordingly, the examples of the embodiments of the present disclosure as set forth above are intended to be illustrative rather than limiting. Various changes may be made without departing from the spirit or scope of the present disclosure. Therefore, the present disclosure is intended to embrace all known or earlier disclosed alternatives, modifications, variations, improvements and/or substantial equivalents.

## Claims

1. A printing system for printing a first board and a second board, the printing system comprising:
a conveying mechanism, the conveying mechanism being used to carry the first board;
a vacuum device, the vacuum device being used to carry the second board; and
a drive component, the drive component driving at least one of the conveying mechanism and the vacuum device to enable the conveying mechanism or the vacuum device to drive the carried board.

2. The printing system according to claim 1, wherein
the drive component is connected to the vacuum device to enable the drive component to drive the vacuum device to move; and
the printing system further comprises a clutch mechanism, the clutch mechanism being configured to:
engage the drive component with the conveying mechanism to enable the drive component to drive the conveying mechanism to move; or
disengage the drive component from the conveying mechanism to enable the drive component to move relative to the conveying mechanism.

3. The printing system according to claim 2, wherein
the conveying mechanism is capable of conveying the first board and the second board in a first direction; and
the drive component is capable of driving at least one of the conveying mechanism and the vacuum device to move in a second direction.

4. The printing system according to claim 3, wherein
the conveying mechanism comprises a pair of conveying portions arranged oppositely in a third direction, and the vacuum device is arranged between the pair of conveying portions.

5. The printing system according to claim 3, wherein
the first board and the second board each comprise an identification code; and
the printing system further comprises an identification device, the identification device being configured to identify the identification codes of the first board and the second board to obtain parameter information.

6. The printing system according to claim 5, further comprising:
a control device, the control device being configured to be capable of receiving the parameter information obtained by the identification device and controlling the drive component and the clutch mechanism according to the parameter information.

7. The printing system according to claim 6, wherein
the control device is configured to:
control, when the first board is identified, the clutch mechanism to engage the drive component with the conveying mechanism such that the drive component simultaneously drives the conveying mechanism and the vacuum device to move so as to enable the conveying mechanism to drive the first board ; and
control, when the second board is identified, the clutch mechanism to disengage the drive component from the conveying mechanism such that the drive component drives the vacuum device to move so as to enable the vacuum device to drive the second board.

8. The printing system according to claim 1, further comprising:
a stencil, the stencil being arranged above the conveying mechanism;
wherein the drive component is configured to enable the conveying mechanism and the vacuum device to drive the carried boards to make the upper surfaces of the board move close to a lower surface of the stencil.

9. The printing system according to claim 2, wherein
the clutch mechanism comprises:
at least one clamp, each of the at least one clamp being connected to the drive component to enable the drive component to drive the clamp to move; and
at least one guide rod, the at least one guide rod being arranged corresponding to the at least one clamp, and each of the at least one guide rod being connected to the conveying mechanism;
wherein each of the at least one clamp is configured to be capable of clamping or releasing the corresponding guide rod to enable the drive component to engage with or disengage from the conveying mechanism.

10. The printing system according to claim 9, further comprising:
a frame, the frame comprising a pair of first beams arranged oppositely in the third direction and a pair of second beamsarranged oppositely in the first direction, the pair of first beams and the pair of second beamsbeing connected to each other to form the frame;
wherein the pair of first beams are connected to the drive component and the clamp, and the pair of second beamsare connected to the conveying mechanism and the guide rod.

11. The printing system according to claim 10, wherein
the at least one clamp includes four clamps, and the at least one guide rod includes four guide rods, the four clamps and the four guide rods being respectively arranged at connections between the respective first beams and the corresponding second beams.

12. A method for controlling a printing system, the method comprising:
identifying a first board and a second board;
conveying the first board and the second board in a first direction to a position aligned with each other; and
driving at least one of a conveying mechanism and a vacuum device to enable the conveying mechanism to drive the first board or enable the vacuum device to drive the second board to a printing position.

13. The method according to claim 12, wherein
driving at least one of a conveying mechanism and a vacuum device to enable the conveying mechanism to drive the first board or enable the vacuum device to drive the second board to a printing position comprises:
allowing the clutch mechanism to engage the drive component with the conveying mechanism, when the first board is identified, to enable the drive component to drive the conveying mechanism and the vacuum device to move together so as to enable the conveying mechanism to drive the first board to move to the printing position; and
allowing the clutch mechanism to disengage the drive component from the conveying mechanism, when the second board is identified, to enable the drive component to move relative to the conveying mechanism and drive the vacuum device to move so as to enable the vacuum device to drive the second board to move to an intermediate position.

14. The method according to claim 13, wherein
driving at least one of a conveying mechanism and a vacuum device to enable the conveying mechanism to drive the first board or enable the vacuum device to drive the second board to a printing position further comprises:
allowing the clutch mechanism to engage the drive component with the conveying mechanism, when the second board is identified and after the second board moves to the intermediate position, to enable the drive component to drive the conveying mechanism and the vacuum device to move together so as to enable the vacuum device to drive the second board to move to the printing position.

15. The method according to claim 12, wherein
identifying a first board and a second board further comprises:
obtaining parameter information of the first board and the second board.
